# EUROPEAN PATENT SPECIFICATION

(11) **EP 1 022 355 B1**
(45) Date of publication and mention of the grant of the patent: **15.09.2004**
(21) Application number: 99870243.5
(22) Date of filing: 30.11.1999
(51) Int. Cl.: C23C 18/40

(54) **Deposition of copper on an activated surface of a substrate**
Absetzung von Kupfer auf einer aktivierten Oberfläche eines Substrats
Dépôt de cuivre sur une surface activée d' un substrat

(30) Priority: 15.01.1999 US 116110 P; 29.04.1999 EP 99870077
(43) Date of publication of application: 26.07.2000
(73) Proprietor: Imec (Interuniversity Microelectronics Center) VZW, 3001 Leuven (BE)
(72) Inventor: Palmans, Roger, 3770 Riemst (BE); Lantasov, Yuri, 3001 Leuven (BE)
(74) Representative: Van Malderen, Joelle

(56) References cited:
- DATABASE WPI Section Ch, Week 198802 Derwent Publications Ltd., London, GB; Class A35, AN 1988-012535 XP002124818 & SU 1 312 119 A (MOSC TEXTILE INST), 23 May 1987 (1987-05-23)

## Description

### Field of the invention

The present invention is related to metal deposition processes as used for instance for the formation of conductive patterns connecting active or passive devices as well as integrated circuits. Particularly, such conductive patterns can be formed at least partly by means of an electroless deposition technique.

### Technological background

Currently, copper is being introduced in ULSI metallization schemes as a replacement for aluminium due to its lower resistivity and better electromigration resistance. Copper electroplating is the most popular deposition technique today. To avoid contamination of the surrounding insulating layers and/or the substrate, copper is mostly deposited on a Cu diffusion barrier layer. However, to allow electroplating, first a conductive seed layer has to be formed on top of the barrier layer(s) in order to get reliable electroplated copper deposition. Usually, a sputtered copper layer is used for this purpose. However, for dual damascene type processing with very high aspect ratio openings in dielectric layers such as trenches, via holes and contact holes, the step coverage of sputtered (classical or by means of an Ion Metal Plasma) barrier layers and Cu seed layers is expected to become the limiting factor for subsequent filling with e.g. electroplated copper. As a consequence, alternative deposition routes for copper seed layer formation can be attractive for future device technologies. Electroless copper deposition has the potential of becoming a viable alternative because it can deliver high step coverage depositions at a very low cost. The principle of electroless metal deposition is based on the generation of electrons at a catalytically active or an activated surface in contact with a solution of metal ions in the presence of a suitable sacrificial electron donor. These electrons are capable of reducing the metal ions leading to the deposition of the metal on the activated surface. Because this process does not occur on non-activated layers, the resulting deposition technique is inherently selective. Furthermore, in principle, it should be easy to integrate such process in currently available copper electroplating tools (which are already on the market or will be so in the near future), provided amongst others that the electroless plating solution is stable at room temperature for at least about two weeks and the process margins of the plating solution are not too tied. Nowadays most electroless copper plating solutions do not meet these specifications. They have often a limited stability and can only be effectively used in a limited pH range which makes them very sensitive for slight variations in the composition of the plating solution as such variations result in small variations in the pH but often lead to a large decrease in the deposition rate.

Moreover, most available electroless copper plating baths do not fulfill the stringent requirements for copper plating in sub-micron high aspect ratio features onto the typical Cu diffusion barrier layers used in ULSI processing. Typical barrier layers are Ti, TiN, Ta, WNₓ, TaN, Co and any combination thereof, and other Cu diffusion barrier layers known in the art. One of the problems of electroless copper deposition on barrier layers and particularly on e.g. TiN is the evolution of copious amounts of hydrogen gas which is detrimental for the quality of the copper layer formed because it leads to severe blistering of the copper layer. The use of cyanide as a hydrogen suppressor, as practiced in many commercial copper plating solutions, is not acceptable in this business due to safety issues. Another problem related to the state-of-the-art plating solutions is the bad adhesion of electroless deposited copper on such barrier layers.

Moreover, most electroless copper plating solution compositions are based on salts containing mainly sodium as the counterion. These high levels of sodium ions in the plating solutions can introduce severe reliability problems, particularly when sodium reaches the semiconductor device junctions, as this is known to be a production yield killer in semiconductor device manufacturing Therefore as a further requirement the level of sodium ions in the plating solution should be very limited or negligible.

Nowadays, electroless copper plating solutions often use EDTA as the complexing agent and formaldehyde as the reducing agent. The complexing agent is required to keep Cu(II) ions in solution at the relatively high pH values at which formaldehyde operates as a reducing agent. Recently, the trend is to move away from strong complexants such as EDTA. Due to their strong complexing power for many metal ions, more stringent requirements for the environment are expected for plating solutions based on strong complexing agents. Consequently, there is a need for other more environmentally acceptable complexing agents.

### Aims of the invention

It is an aim of the invention to provide a plating solution for electroless copper deposition which is substantially sodium free (low level sodium) and which comprises an environmentally friendly complexing agent. The plating solution should have a long life-time after make-up (thermal stability) of at least two weeks at room temperature and should be easy to replenish to keep the plating characteristics well within spec over the plating periods. Furthermore, slight variations in the composition of the plating solution may cause only small variations in the Cu deposition rate on an activated surface of a substrate immersed in the plating solution.

It is another aim of the invention to provide a method to form Cu-containing layers on an activated surface of a substrate by means of an electroless deposition technique using the plating solution of the present invention. This plating solution and deposition method should be such that the formation of hydrogen gas during the plating period is avoided or severely limited. Particularly, this method has to result in a sufficiently high deposition rate at low temperatures.

A further aim of the invention is to provide a Cu seed layer on a diffusion barrier layer, said diffusion barrier layer may act simultaneously as a wetting layer. Particularly when a Cu-containing layer is deposited on a barrier layer, the Cu-containing layer has to be formed with good adhesion on the diffusion barrier layer. Seed layers have typically a thickness below 300 nm.

Still a further aim of the invention is to provide a Cu plating solution suitable to form a relatively thick Cu-containing layer on a barrier layer or an a seed layer. This is particularly useful to fill up openings with high aspect ratios in insulating layers such as via holes, trenches and contact holes like e.g. in damascene architectures. The Cu-containing layers formed have typically a thickness between 200 nm and 2 µm.

### Summary of the invention

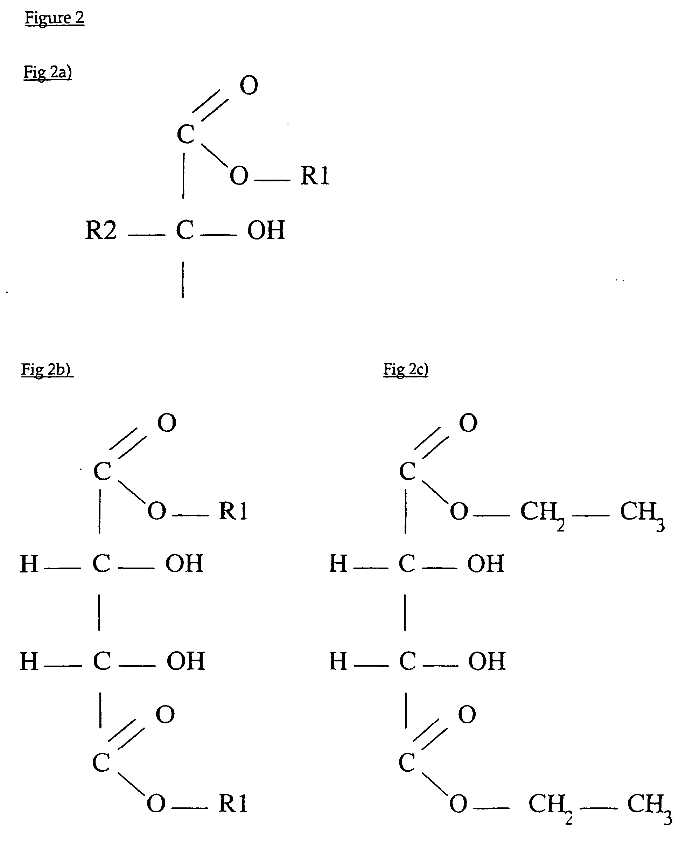

The present invention is related to the fabrication of at least a part of a Cu-containing layers or a Cu-containing pattern used for the electrical connection of active or passive devices as well as integrated circuits. Such Cu-containing patterns and/or layers can be formed on an activated surface of a substrate by means of immersion of said substrate in an electroless plating solution. Therefore, in an aspect of the present invention, a aqueous solution for electroless deposition of Cu on a substrate is disclosed, said solution comprising :
a source of copper Cu (II) ions;
a reducing agent;
an additive to adjust the pH of said aqueous solution to a predetermined value; and
a chemical compound for complexing said Cu ions, said chemical compound having at least one part with chemical structure COOR1-COHR2 (as can be seen in fig. 2a)), R1 being a first organic group covalently bound to the carboxylate group (COO), R2 being either hydrogen or a second organic group. Examples of such first or second organic groups are hydrocarbon groups, while for instance the chemical compound for complexing the Cu ions can be selected from the group consisting of diethyltartrate, diisopropyltartrate and diethyllactate. The pH of the plating solution ranges typically from 11 or 11.5 to 13.5, while the temperature at which the solution can be applied ranges from 10 to 50 degrees C or, 45 degrees C or below, or from room temperature to 40 degrees C. Examples of a reducing agent are formaldehyde, paraformaldehyde, hydrazine, amine boranes, alkali metal borohydrides, alkali metal hypophosphites or a derivative of on of the aforementioned reducing agents.

In an embodiment of the invention, a Cu plating solution is disclosed based on an organic based complexing agent, wherein the ratio between the concentration of said source of copper Cu (II) ions and the concentration of said complexing agent in said solution is in the range from 1/5 to 5/1 or from 1/10 to 10/1 or from 1/25 to 25/1.

In another embodiment of the invention, a Cu plating solution is disclosed wherein the complexing agent is a chemical compound with chemical structure COOR1-CHOH-CHOH-COOR1, R1 being an organic group covalently bound to the carboxylate group (COO). For instance, hydrocarbon groups can be used as organic groups. Particularly, a chemical compound selected from the group consisting of diethyltartrate, diisopropyltartrate and dimethyltartrate can be selected.

In another aspect of the invention, a method is disclosed for forming a Cu-containing layer on a substrate comprising the steps of:
preparing an aqueous solution comprising a source of copper Cu (II) ions, a reducing agent, a chemical compound for complexing said Cu (II) ions, said chemical compound having at least one part with chemical structure COOR1-COHR2, R1 being an organic group covalently bound to the carboxylate group (COO), R2 being either hydrogen or an organic group, and an additive to adjust the pH of the solution to a predetermined value;
immersing said substrate in said aqueous solution for a predetermined period to thereby form said Cu-containing layer at least on an activated surface of said substrate. For instance, this Cu-containing layer can be formed on a Cu diffusion barrier layer formed on the substrate.

In an embodiment, a method for filling an opening in an insulating layer is disclosed, wherein, after forming at least one opening in an insulating layer formed on a substrate, a barrier layer can be formed on at least one inner wall of said opening. Examples of such openings are via holes, contact holes, and trenches. Examples of such barrier layers are layers of Ti, or TiN, or Ta, or WN-ₓ, or TaN, or Co or a combination thereof. Particularly this barrier layer can also act as a wetting layer like e.g. a TiN layer with a Ti layer thereon. A Cu-containing metal, i.e. an alloy of or pure Cu, is deposited using the electroless plating solution of the present invention. This electroless deposition can be performed in a chamber of a electro-deposition tool. The electroless deposition can be performed in at least one deposition step to thereby completely fill the openings. Alternatively, first a thin Cu-containing seed layer can be formed using the de electroless deposition method of the present invention, thereafter a second Cu-containing metal can be deposited on said seed layer using a different Cu deposition technique as e.g. electroplating of Cu to thereby completely fill the openings.

### Brief description of the drawings

Figure 1 depicts the deposition rate of a tartrate²⁻ ions based salt Cu plating solution versus the pH value of the solution.

Figure 2 depicts three different chemical structures. According to the present invention, in fig 2 a) a chemical compound for complexing Cu ions is depicted having at least a part with chemical structure COOR1-COHR2, R1 being a first organic group covalently bound to the carboxylate group (COO), R2 being either hydrogen or a second organic group, while in fig 2b) a chemical compound with chemical structure COOR1-CHOH-CHOH-COOR1 is depicted, and fig. 2c) depicts the chemical structure of diethyltartrate.

Figure 3 depicts, according to an embodiment of the invention, the deposition rate of a diethyltartrate based Cu plating solution versus the pH value of the solution.

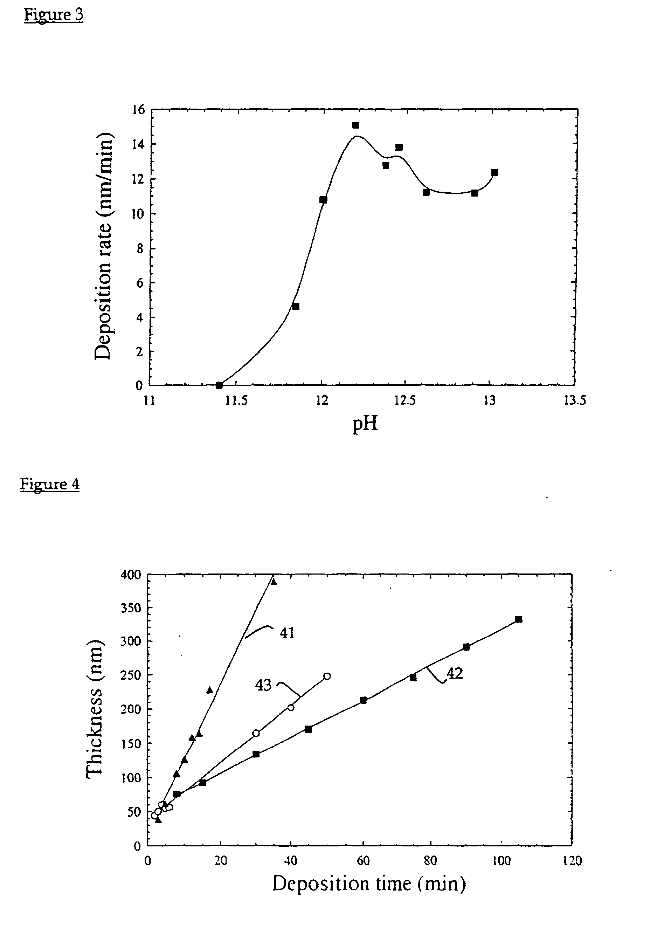

Figure 4 depicts, according to an embodiment of the invention, the thickness of the deposited Cu layer versus deposition time using electroless deposition of three different plating solutions being a tartrate²⁻ ions based salts plating solution comprising CuSO₄ in an amount of 0.0144 mol/l and a tartrate²⁻ ions based salt in an amount of 0.0166 mol/l (42); a tartrate²⁻ ions based salts plating solution comprising CuSO₄ in an amount of 0.0443 mol/l and a tartrate²⁻ ions based salt in an amount of 0.0499 mol/l (43); a diethyltartrate based plating solution comprising CuSO₄ in an amount of 0.0288 mol/l and diethyltartrate in an amount of 0.1461 mol/l (41).

Figure 5 depicts, according to an embodiment of the invention, the thickness of the deposited Cu layer versus the deposition temperature using electroless deposition of a diethyltartrate based electroless plating solution.

Figure 6 depicts, according to an embodiment of the invention, the deposition rate of a diethyltartrate based plating solution versus the concentration of CuSO₄ in the solution for two different compositions of the solution being a solution with diethyltartrate in an amount of 0.1461 mol/l (61); and a solution with diethyltartrate in an amount of 0.256 mol/l (62);.

Figure 7 depicts, according to an embodiment of the invention, Cu seed layers formed using a electroless deposition of a diethyltartrate based plating solution, on top of a Ti/TiN stack. This Ti/TiN stack is formed on wafers (substrates) with single damascene trench test structures having widths down to 0.4 micron and aspect ratio of 2.5.

Figure 8 depicts the same single damascene trench test structures as in figure 5 wherein these trench structures are completely filled with Cu using an electroplating technique.

### Detailed description of the invention

In relation to the appended drawings the present invention is described in detail in the sequel. It is apparent however that a person skilled in the art can imagine several other equivalent embodiments or other ways of executing the present invention, the spirit and scope of the present invention being limited only by the terms of the appended claims.

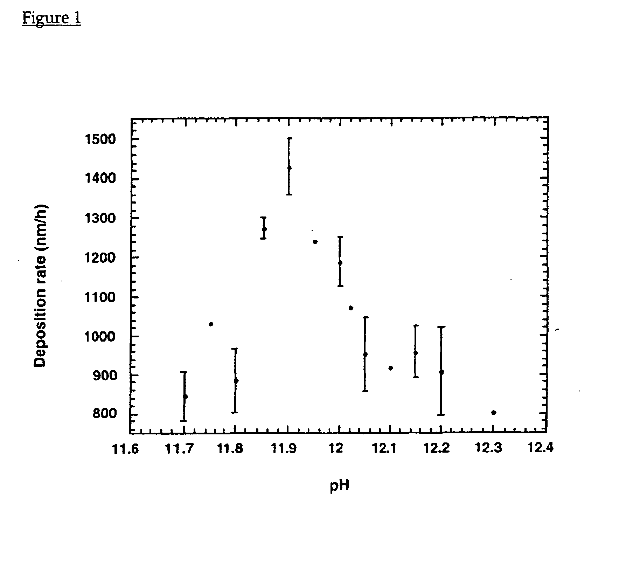

The use of tartrate²⁻ ions based salts as a complexing agents for copper(II) ions in electroless plating solutions is known for many years. However, only the sodium, potassium and NaK (Rochelle salt) salt have been used extensively in electroless copper plating solution compositions. A disadvantages of the latter type of plating solution is the very low deposition rate at room temperature. Another disadvantage is the sensitivity of these state-of-the-art complexing agents for small variations in the composition of the plating solution which directly affects the pH of the solution. Therefore even if one succeeds in obtaining a more or less stable initial solution, while, plating proceeds, a small change in the composition and consequently in the pH of the solution caused by the deposition of Cu causes dramatic changes in the deposition rate due to the limited width of the pH window at which the deposition rate is more or less constant (as e.g. in fig.1).

A further disadvantage is that electroless deposition using a plating solution based on tartrate²⁻ ions based salts leads to hydrogen gas evolution which not only prevents deposition of layers with a thickness above 150 nm, but also thinner layers (below 150 nm) are of bad quality due to hydrogen inclusion in the deposited layer. A further disadvantage of electroless deposition using a plating solution of these tartrate²⁻ ions based salts containing mainly sodium or potassium as counterion is that these counterions are highly mobile and easily migrate to the junction level of the semiconductor devices which is detrimental for the reliability of these devices.

Moreover, it should be stated that successful plating of electroless copper on an arbitrary surface of a substrate involves both cleaning of the surface and activation with Pd nuclei prior to copper plating.

In a preferred embodiment of the invention, a method is disclosed for forming a Cu-containing layer on an activated surface of a Cu-diffusion barrier layer formed on a substrate comprising the steps of:
preparing an aqueous solution comprising a source of copper Cu (II) ions, a reducing agent, a chemical compound for complexing Cu (II) ions, said chemical compound having chemical structure COOR1-CHOH-CHOH-COOR1 (as in fig.2b)), R1 being an organic group covalently bound to the carboxylate group (COO) .and an additive to adjust the pH of the solution to a predetermined value;
immersing said substrate with said Cu-diffusion barrier layer in said aqueous solution for a predetermined period to thereby form said Cu-containing layer at least on said activated surface of said Cu-diffusion barrier layer.

At least for the purpose of this disclosure, an organic tartrate is defined as a chemical compound with chemical structure COOR1-CHOH-CHOH-COOR1, R1 being an organic group covalently bound to the carboxylate group (COO). For instance, these organic groups can be hydrocarbon groups. Examples of such organic tartrates are diethyltartrate (fig.2c)), diisopropyltartrate and dimethyltartrate.

In order to avoid copper(II)hydroxide deposition at high pH values, an organic tartrate is added for complexing the Cu(II) ions. Particularly, diethyltartrate, is used. The organic tartrates are characterized by a different complexation behaviour with Cu(II) ions as compared to ionic tartrate, i.e. tartrate²⁻ ions based salts. Although the precise nature of the complexation behaviour is not fully understood, experiments demonstrate that deposition using the plating solution of the present invention, i.e. an organic tartrate based solution, unexpectedly overcomes or at least substantially limits the hydrogen evolution during the deposition process, probably due to the different complexing behavior, particularly when a deposition is performed on a barrier layer. It is believed that when adding an organic tartrate to the solution, in contrast to adding tartrate²⁻ ions based salts, no carboxylate ions are created. As a consequence, the complexation of Cu(II) ions occurs mainly at higher pH values. Probably this complexation is mainly, but not limited hereto, based on at least one hydroxyl group of the organic tartrate, particularly on the corresponding anion.

CuSO₄.5H₂O can be used as a source of copper Cu (II) ions or other sources known in the art. Formaldehyde acts as a sacrificial electron donor, i.e. a reducing agent. The invention is in no way limited to the use of formaldehyde as sacrificial electron donor. Formaldehyde vapors are a potential health liability because of suspected carcinogenity. However, on e could opt to use the solid form, i.e. paraformaldehyde which is less dangerous. One could also opt to add paraformaldehyde to the solution provided that first the plating solution is brought to a higher pH. This probably further limits health risks.

The operation range for the pH of this plating solution is typically between pH 11.5 and 13.5. The correct pH value is adjusted by addition of an additive like e.g. tetra-N-methylammoniumhydroxide (Me₄NOH). Other examples are the alkali metal hydroxides or others known in the art.

The substrate can be at least a part of a partly processed or a pristine wafer or slice of a semiconductive material, like e.g. Si or GaAs or Ge or SiGe, or an insulating material, like e.g. a glass slice, or a conductive material. Said substrate can comprise a patterned insulating layer. Particularly, in case said substrate is a partly processed wafer or slice; at least a part of the active and/or passive devices can already be formed and/or at least a part of the structures interconnecting these devices can be formed.

Examples of Cu diffusion barrier layers are Ti, TiN, Ta, WNₓ, TaN, Co or any combination thereof. A more particular example of such a barrier layer is TiN. When stating that the hydrogen evolution is substantially limited during deposition on a barrier layer, this means that on such barrier layers high quality Cu-containing layers with a thickness of at least 150 nm or at least 300 nm can be formed. Also thicker layers can be formed e.g. layers with a thickness ranging up to 1 µm or even up to 2 µm.

The electroless plating of copper on barrier layers involves both cleaning of the barrier layer surface and activation of the clean barrier layer with Pd nuclei prior to copper plating. For instance, cleaning of a TiN surface can be accomplished with dilute HF solutions in order to remove surface TiOₓN_{y} species. Other cleaning procedures have been described in the literature. Activation is accomplished by treatment of the clean TiN surface with a Palladium activator solution, typically containing PdCl₂ and HCl in aqueous solution. Optional additives are HF and/or acetic acid, as known in the art. It is understood that each process step should be followed by an adequate rinse, for instance with DI water, as usually required in the art. In some instances, depending on the quality of the TiN surface, additional drying after either pre-clean or activation step, or after both steps, can improve the electroless copper layer quality.

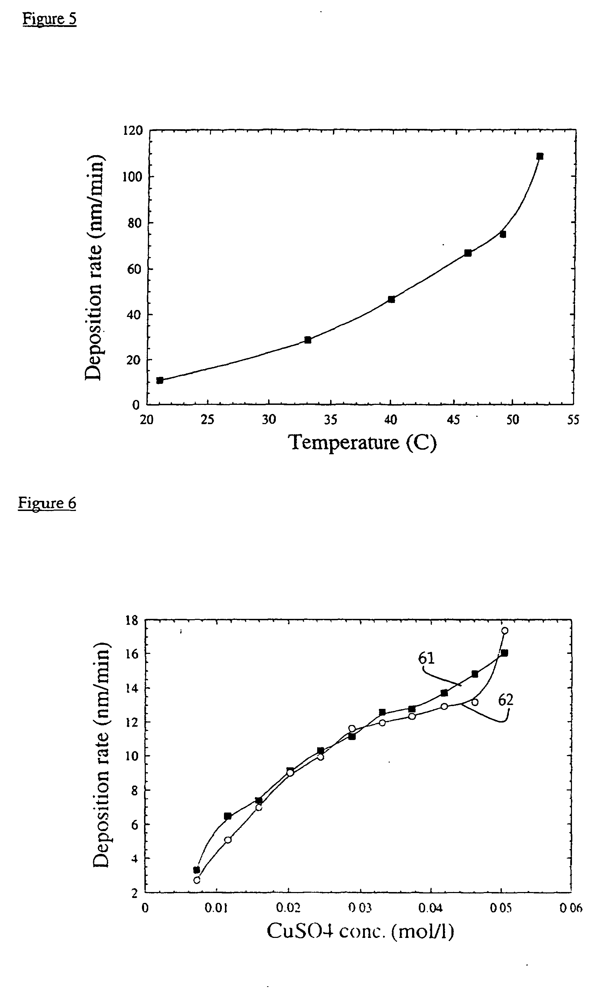

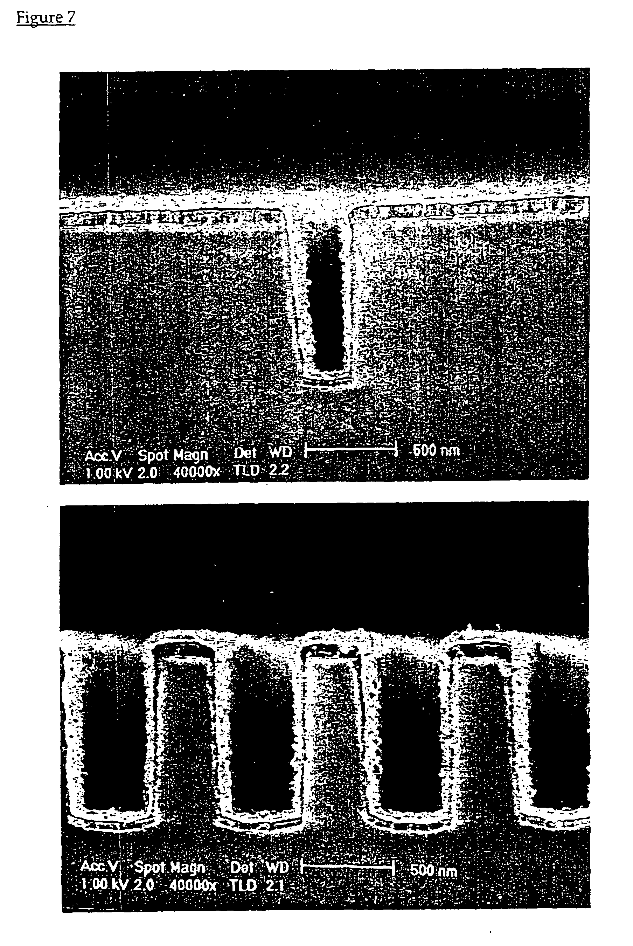

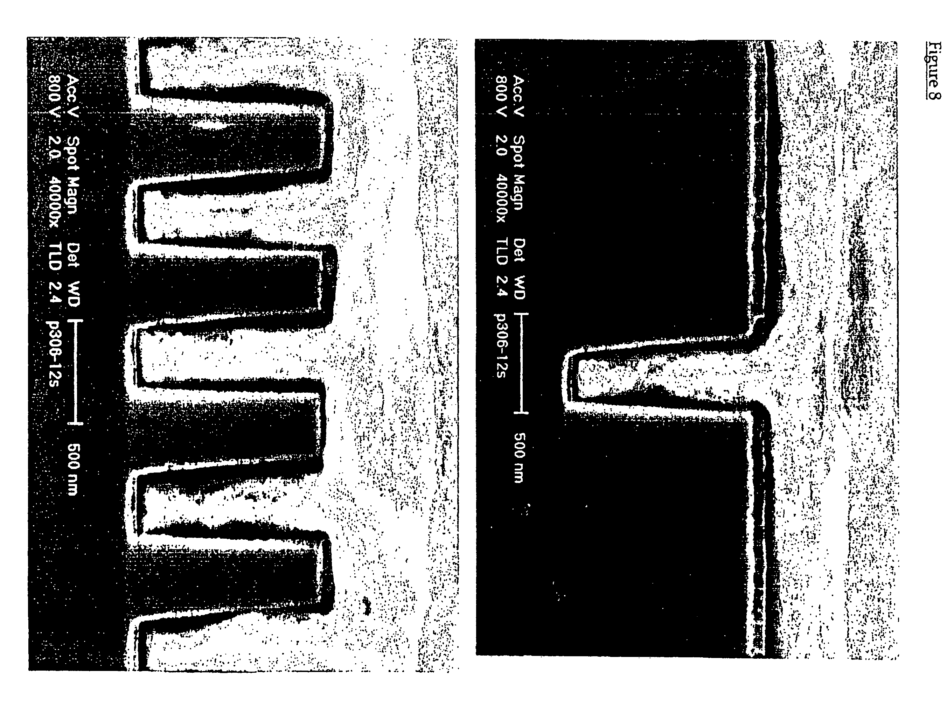

Electroless plating can be performed at temperatures up to 55 °C. However, the stability of the plating solution deteriorates substantially when the plating solution is kept at temperatures above about 45 °C. For instance, the stability of the solution was found to be reduced to approximately 1 day at 40 °C as compared to more than 30 days at room temperature. Consequently, preferably the temperature range for electroless plating with the plating solution of the present invention is between 20 and 40 °C. The copper deposition rate follows a perfect Arrhenius behaviour in function of the temperature of the solution with an activation energy of 56.13 kJ mol⁻¹ (41) (see fig. 4 and 5)) in the temperature range between 20 and 55 °C. As depicted in Fig.5 deposition rates are 31.6 nm min⁻¹ at 34 °C and 46.4 nm min⁻¹ at 40 °C, respectively. In case a conventional tartrate²⁻ ions based salt plating solution is used then the deposition rates (42) (43) are substantially lower.

As a best mode embodiment of the invention, a plating solution is disclosed having the following composition: Cu²⁺ (as CuSO₄.5H₂O) (0.029 M), diethyltartrate (0.146 M), and formaldehyde (0.67 M). The pH is adjusted with [Me₄N]OH to an optimum value of 12.5. The procedure for making up the plating bath involves mixing of the Cu(II) and diethyltartrate stock solutions, adding water to almost final volume, first pH adjustment to 12.5; addition of formaldehyde, re-establishing the pH value to 12.5, and finally adding water to the final solution volume. The stability of this solution at room temperature exceeds 30 days which is an important improvement compared with conventional plating solutions which have a limited stability of typically one week or at most two weeks. Decrease of the copper ion concentration in the plating solution results in lower deposition rates as can be seen in Fig. 6. However, the copper layer characteristics do not change appreciably by changing the copper concentration and/or by changing the organic tartrate concentration (61) (62) in the plating solution of the present invention. Also, the formaldehyde concentration is not that critical for obtaining a good copper quality; however too large an excess should be avoided because hydrogen evolution is favored at higher formaldehyde concentration levels, i.e. more than about 1 M. This decreased sensitivity of the precise amounts in the plating solution composition and the increased stability of the organic tartrate based plating solution makes this plating solution suitable for industrial application.

Further according to this example, a Cu-containing layer is formed on a Ti/TiN stack. The Ti/TiN was deposited by means of a physical vapor deposition (PVD) process. Deposition can also be executed by means of ALCVD. The following characteristics for the plating process and the deposited copper layers are obtained. In the pH range between 12.0 and 13.0, as in Fig. 3, the deposition rate amounts to approximately 13 nm per minute at room temperature (21 °C) and does not change with deposition time (thickness increases linearly with deposition time). Specific resistivity values between 4.10 and 4.65 µΩ cm are obtained for a layer thickness in the range of 275 to 300 nm. Thinner layers of electroless copper have higher resistivity values, as is also known from copper films deposited by PVD and especially by chemical vapor deposition (CVD) methods. For instance, a 110 nm thick electroless copper film shows a specific resistivity of 5.63 µΩ cm. However, deposition at higher temperatures results in a significant decrease of the specific resistivity of electroless copper layers deposited with the plating solution of the present invention. For instance, a copper film of 160 nm deposited at 40 °C shows a specific resistivity of only 4.0 µΩ cm. Typical sheet resistance uniformity over a 6 inch wafer with a PVD deposited Ti/TiN stack is around 6.6 % (standard deviation, 1 sigma, as measured over 49 points by a four-point probe measurement).

The deposition of Cu films as seed layers for Cu electroplating (with the ECD technique) is compared for an electroless plating method according to the best mode embodiment of the invention, and for copper films deposited with the PVD technique. Electroless Cu seed layers and ECD Cu films were deposited in an EQUINOX tool as commercially available from the company SEMITOOL. 6" silicon wafers with different width trenches are used. The trenches are etched in an oxide layer formed on the silicon wafer. Trench depth was 1 µm and 1.2 µm, for different lots of wafers. 1 µm thick ECD Cu films were deposited on 80 nm Cu seed layers (electroless or PVD) on 15 nm/60 nm of Ti/TiN layers. Electroless Cu seed layers are deposited in Equinox at standard conditions from Na-free electroless bath followed by a RTP anneal (350 C, 2 min, N2). A second anneal step was performed after ECD copper deposition. Thereafter an edge bead removal step, CMP, and post-CMP clean (H₂O) were done. Wafers were electrically tested after CMP. Some of the wafers were used for FIB SEM (FEI200) and SEM (Philips XL30) analysis. The copper seed layers deposited from the Na-free electroless copper bath, according to the best mode embodiment of the invention, had good uniformity and conformality in trenches with aspect ratio of at least up to 3. ECD copper deposited on electroless Cu seed layers showed excellent filling capability in 1.2 µm as well as in 1 µm deep trenches. Trenches with different widths (from 0.3 µm up to 10 µm) were electrically measured. The results show that electroless Cu seed layers can be deposited in trenches with an aspect ratio of at least up to 3.5 (1.2 µm : 0.35 µm). ECD Cu films plated on electroless Cu seed layers have reasonable effective specific resistivity - about 2.3 µΩ-cm for trenches with width from 0.35 µm to 0.7 µm and 2.12 µΩ-cm for 3 µm width trenches. Similar results are obtained for ECD Cu films deposited on PVD Cu seed layers.

Further according to the method of the present invention, a method for filling an opening in an insulating layer is disclosed, wherein, after forming at least one opening in an insulating layer formed on a substrate, a barrier layer is formed on at least one inner wall of said opening. A Cu-containing metal, i.e. an alloy of or pure Cu, is deposited using the electroless plating solution of the present invention. This deposition can be performed in a chamber of a electroplating tool. The obtained Cu layer can be used as seed layer (as in Fig. 7) for the deposition of electroplated copper on both blanket wafers, i.e. without openings, and wafers with single damascene trench test structures with widths down to 0.4 micron and with an aspect ratio of 2.5. For instance on this seed layer, a second Cu-containing metal layer can be formed by means of electroplating. As an example, excellent filling (fig. 8) is obtained with such a combination of layers on top of a Ti/TiN stack. Adhesion is adequate for a layer thickness as typically required for seed layer applications. Anneal in inert atmosphere (nitrogen) of the seed layer prior to copper electroplating results in good adhesion of the total layer with a thickness up to at least 1.1 micron, but the invention is in no way limited to this thickness range.

The method of the present invention can be used for the fabrication of integrated circuits, particularly in sub 0.35 µm CMOS or BiCMOS processes. Particularly these integrated circuits comprise interconnect structures wherein during the process of forming said interconnect structures openings, e.g. via openings or contact openings or trenches, with a sub 0.5 µm diameter and with high aspect ratios, i.e. typically with an aspect ratio of 2:1 or higher, have to be filled. The method of the present invention allows at least forming of high quality Cu-containing seed layers in a reliable way but also complete filling of these openings can be obtained. Particularly in an embodiment of the invention an integrated circuit comprising an interconnect structure is disclosed, wherein the process of forming said interconnect structure comprises the method of the present invention for creating Cu-containing metal layers on a Cu diffusion barrier layer.

## Claims

1. An aqueous solution for electroless deposition of Cu on a substrate comprising :
a source of copper Cu (II) ions;
a reducing agent;
an additive to adjust the pH of said aqueous solution to a predetermined value; and
a chemical compound for complexing said Cu ions, said chemical compound having at least one part with chemical structure COOR1-COHR2, R1 being a first organic group covalently bound to the carboxylate group (COO), R2 being either hydrogen or a second organic group.

2. The solution as recited in claim 1, wherein the pH of said aqueous solution is in the range from 11.0 to 13.5, preferably in the range from 11.5 to 13.5.

3. An aqueous solution for electroless deposition of Cu on a substrate as defined in claim 1 wherein the temperature of said aqueous solution for electroless deposition of Cu is 45 degrees C or below about 1-1.5 M.

4. The solution as recited in claim 1, wherein said reducing agent is formaldehyde or paraformaldehyde having a concentration of below 1M.

5. The solution as recited in claim 1 and 4, wherein said first organic group is a hydrocarbon group.

6. The solution as recited in claim 5, wherein said chemical compound is selected from the group consisting of diethyltartrate, diisopropyltartrate and diethyllactate.

7. An aqueous solution for electroless deposition of Cu on a substrate comprising :
a source of copper Cu (II) ions;
a reducing agent;
an additive to adjust the pH of said aqueous solution to a predetermined value; and
a chemical compound for complexing Cu (II) ions, said chemical compound having chemical structure COOR1-CHOH-CHOH-COOR1, R1 being an organic group covalently bound to the carboxylate group (COO).

8. The solution as recited in claim 7, wherein the pH of said aqueous solution is in the range between 11.0 and 13.5 and wherein said reducing agent is formaldehyde or paraformaldehyde.

9. The solution as recited in claim 7, wherein said organic group is a hydrocarbon group.

10. The solution as recited in claim 7 , wherein said chemical compound is selected from the group consisting of diethyltartrate, diisopropyltartrate and dimethyltartrate.

11. A method for forming a Cu-containing layer on a substrate comprising the steps of:
preparing an aqueous solution comprising a source of copper Cu (II) ions, a reducing agent, a chemical compound for complexing said Cu (II) ions, said chemical compound having at least one part with chemical structure COOR1-COHR2, R1 being an organic group covalently bound to the carboxylate group (COO), R2 being either hydrogen or an organic group, and an additive to adjust the pH of the solution to a predetermined value;
immersing said substrate in said aqueous solution for a predetermined period to thereby form said Cu-containing layer at least on an activated surface of said substrate.

12. The method as recited in claim 11, wherein said Cu-containing layer is formed on an activated surface of a Cu diffusion barrier layer formed on the substrate

13. The method as recited in claim 12, wherein said Cu diffusion barrier layer is at least one layer selected from the group consisting of a Ti layer, a TiN layer, a Ta layer, a WNₓ layer, a TaN layer, and a Co layer.

14. The method as recited in claim 12 and 13, wherein said chemical compound is selected from the group consisting of diethyltartrate, diisopropyltartrate and dimethyltartrate.

15. The method as recited in claim 14, wherein the pH of said aqueous solution is in the range between 11.0 and 13.5, preferably in the range of about 11.5 tot 13.5.

16. The method as recited in claim 11, wherein after preparing said aqueous solution, said substrate and said solution are introduced in a chamber of an electroplating tool.

17. The method as recited in claim 16, wherein after immersing said substrate in said aqueous solution, a Cu-containing metal is deposited on said Cu-containing layer formed on said substrate in a chamber of said electroplating tool by means of electroplating.

18. The method as recited in claim 17, wherein the thickness of said Cu-containing layer is between 100 nm and 2000 nm, preferably below about 600 nm and below about 250 nm.

## Patentansprüche

1. Wässrige Lösung für eine stromlose Kupferabscheidung auf einem Substrat, welche umfasst:
• eine Quelle für Kupfer Cu (II)-ionen;
• ein Reduktionsmittel;
• ein Additiv, um den pH-Wert der besagten wässrigen Lösung auf einen vorher bestimmten Wert einzustellen; und
• eine chemische Verbindung als ein Komplexbildner für die besagten Cu-Ionen, wobei die besagte chemische Verbindung mindestens einen Teil mit einer chemischen Struktur COOR1-COHR2 aufweist, wobei R1 eine erste organische Gruppe darstellt, welche kovalent an die Carboxylatgruppe (COO) gebunden ist, und wobei R2 entweder Wasserstoff oder eine zweite organische Gruppe ist.

2. Lösung gemäß Anspruch 1, wobei der pH-Wert der besagten wässrigen Lösung in dem Bereich von 11,0 bis 13,5 liegt, vorzugsweise in dem Bereich von 11,5 bis 13,5.

3. Wässrige Lösung für eine stromlose Kupferabscheidung auf einem Substrat gemäß Anspruch 1, wobei die Temperatur der besagten wässrigen Lösung für die stromlose Kupferabscheidung bei 45 Grad C oder darunter liegt.

4. Lösung gemäß Anspruch 1, wobei das besagte Reduktionsmittel aus Formaldehyd oder aus Paraformaldehyd mit einer Konzentration von unter 1M besteht.

5. Lösung gemäß den Ansprüchen 1 und 4, wobei die besagte erste organische Gruppe eine Kohlenwasserstoffgruppe ist.

6. Lösung gemäß Anspruch 5, wobei die besagte chemische Verbindung ausgewählt wird aus der Gruppe bestehend aus Diethyltartrat, Diisopropyltartrat und aus Diethyllactat.

7. Wässrige Lösung für eine stromlose Kupferabscheidung auf einem Substrat, welche umfasst:
• eine Quelle für Kupfer Cu (II)-ionen;
• ein Reduktionsmittel;
• ein Additiv, um den pH-Wert der besagten wässrigen Lösung auf einen vorher bestimmten Wert einzustellen; und
• eine chemische Verbindung als ein Komplexbildner der Cu (II)-Ionen, wobei die besagte chemische Verbindung eine chemische Struktur COOR1-CHOH-CHOH-COOR1 aufweist, und wobei R1 eine organische Gruppe darstellt, welche kovalent an die Carboxylatgruppe (COO) gebunden ist.

8. Lösung gemäß Anspruch 7, wobei der pH-Wert der besagten wässrigen Lösung in dem Bereich zwischen 11,0 bis 13,5 liegt und wobei das besagte Reduktionsmittel aus Formaldehyd oder aus Paraformaldehyd besteht.

9. Lösung gemäß Anspruch 7, wobei die besagte organische Gruppe eine Kohlenwasserstoffgruppe ist.

10. Lösung gemäß Anspruch 7, wobei die besagte chemische Verbindung ausgewählt wird aus der Gruppe bestehend aus Diethyltartrat, Diisopropyltartrat und aus Dimethyltartrat.

11. Verfahren zur Herstellung einer Cu-enthaltenden Schicht auf einem Substrat, welches die nachfolgenden Schritte umfasst:
• das Herstellen einer wässrigen Lösung, welche enthält; eine Quelle für Kupfer Cu (II)-ionen, ein Reduktionsmittel, eine chemische Verbindung als ein Komplexbildner für die besagten Cu(II)-Ionen, wobei die besagte chemische Verbindung mindestens einen Teil mit einer chemischen Struktur COOR1-COHR2 aufweist, wobei R1 eine organische Gruppe darstellt, welche kovalent an die Carboxylatgruppe (COO) gebunden ist, und wobei R2 entweder Wasserstoff oder eine organische Gruppe ist, sowie ein Additiv, um den pH-Wert jener Lösung auf einen vorher bestimmten Wert einzustellen;
• ein Eintauchen des besagten Substrats in die besagte wässrige Lösung während einer vorher festgelegten Zeitdauer, um auf diese Weise die besagte Cu-enthaltende Schicht mindestens auf einer aktivierten Oberfläche des besagten Substrats herzustellen.

12. Verfahren gemäß Anspruch 11, wobei die besagte Cu-enthaltende Schicht hergestellt wird auf einer aktivierten Oberfläche einer Cu-Diffusionsbarriereschicht, welche auf dem Substrat gebildet worden ist.

13. Verfahren gemäß Anspruch 12, wobei die Cu-Diffusionsbarriereschicht aus mindestens einer Schicht besteht, welche ausgewählt wird aus der Gruppe bestehend aus einer Ti-Schicht, einer TiN-Schicht, einer Ta-Schicht, einer WNₓ-Schicht, einer TaN-Schicht und einer Co-Schicht.

14. Verfahren gemäß den Ansprüchen 12 und 13, wobei die besagte chemische Verbindung ausgewählt wird aus der Gruppe bestehend aus Diethyltartrat, Diisopropyltartrat und aus Dimethyltartrat.

15. Verfahren gemäß Anspruch 14, wobei der pH-Wert der besagten wässrigen Lösung in dem Bereich zwischen 11,0 bis 13,5 liegt, vorzugsweise in dem Bereich von etwa 11,5 bis 13,5.

16. Verfahren gemäß Anspruch 11, wobei nach dem Herstellen der besagten wässrigen Lösung das besagte Substrat und die besagte Lösung in eine Kammer einer Vorrichtung zum Elektroplattieren eingeführt werden.

17. Verfahren gemäß Anspruch 16, wobei nach dem Eintauchen des besagten Substrats in die besagte wässrige Lösung ein Cu-enthaltendes Metall auf der besagten Cu-enthaltenden Schicht abgeschieden wird, welche auf dem besagten Substrat in einer Kammer der besagten Vorrichtung zum Elektroplattieren mit Hilfe des Elektroplattierens hergestellt worden ist.

18. Verfahren gemäß Anspruch 17, wobei die Dicke der besagten Cu-enthaltenden Schicht zwischen 100 nm und 2000 nm liegt, vorzugsweise unterhalb von etwa 600 nm und unterhalb von etwa 250 nm.

## Revendications

1. Solution aqueuse pour un dépôt autocatalytique de Cu sur un substrat comprenant:
une source d'ions cuivre Cu (II);
un agent réducteur;
un additif pour ajuster le pH de ladite solution aqueuse à une valeur prédéterminée; et
un composé chimique pour complexer lesdits ions Cu, ledit composé chimique possédant au moins une partie avec la structure chimique COOR1-COHR2, R1 étant un premier groupe organique lié par covalence au groupe carboxylate (COO), R2 étant soit un hydrogène, soit un deuxième groupe organique.

2. Solution selon la revendication 1, dans laquelle le pH de ladite solution aqueuse est dans l'intervalle de 11,0 à 13,5, de préférence dans l'intervalle de 11,5 à 13,5.

3. Solution aqueuse pour un dépôt autocatalytique de Cu sur un substrat selon la revendication 1, dans laquelle la température de ladite solution aqueuse pour un dépôt autocatalytique de Cu est de 45 degrés C ou moins.

4. Solution selon la revendication 1, dans laquelle ledit agent réducteur est le formaldéhyde ou le paraformaldéhyde avec une concentration en dessous de 1 M.

5. Solution selon les revendications 1 et 4, dans laquelle ledit premier groupe organique est un groupe hydrocarbure.

6. Solution selon la revendication 5, dans laquelle ledit composé chimique est choisi dans le groupe constitué de diéthyltartrate, de diisopropyltartrate et de diéthyllactate.

7. Solution aqueuse pour un dépôt autocatalytique de Cu sur un substrat comprenant:
une source d'ions cuivre Cu (II);
un agent réducteur;
un additif pour ajuster le pH de ladite solution aqueuse à une valeur prédéterminée; et
un composé chimique pour complexer les ions Cu (II), ledit composé chimique possédant la structure chimique COOR1-CHOH-CHOH-COOR1, R1 étant un groupe organique lié par covalence au groupe carboxylate (COO).

8. Solution selon la revendication 7, dans laquelle le pH de ladite solution aqueuse est dans l'intervalle de 11,0 à 13,5 et dans laquelle ledit agent réducteur est le formaldéhyde ou le paraformaldéhyde.

9. Solution selon la revendication 7, dans laquelle ledit groupe organique est un groupe hydrocarbure.

10. Solution selon la revendication 7, dans laquelle ledit composé chimique est choisi dans le groupe constitué de diéthyltartrate, de diisopropyltartrate et de diméthyltartrate.

11. Procédé pour la formation d'une couche contenant du Cu sur un substrat comprenant les étapes:
de préparation d'une solution aqueuse comprenant une source d'ions cuivre Cu (II), un agent réducteur, un composé chimique pour complexer lesdits ions Cu (II), ledit composé chimique possédant au moins une partie avec la structure chimique COOR1-COHR2, R1 étant un groupe organique lié par covalence au groupe carboxylate (COO), R2 étant soit un hydrogène, soit un groupe organique, et un additif pour ajuster le pH de la solution à une valeur prédéterminée;
d'immersion dudit substrat dans ladite solution aqueuse pendant une période prédéterminée pour former ainsi ladite couche contenant du Cu au moins sur une surface activée dudit substrat.

12. Procédé selon la revendication 11, dans lequel ladite couche contenant du Cu est formée sur une surface activée d'une couche barrière de diffusion de Cu formée sur le substrat.

13. Procédé selon la revendication 12, dans lequel ladite couche barrière de diffusion de Cu est au moins une couche choisie dans le groupe constitué d'une couche de Ti, d'une couche de TiN, d'une couche de Ta, d'une couche de WNₓ, d'une couche de TaN et d'une couche de Co.

14. Procédé selon les revendications 12 et 13, dans lequel ledit composé chimique est choisi dans le groupe constitué de diéthyltartrate, de diisopropyltartrate et de diméthyltartrate.

15. Procédé selon la revendication 14, dans lequel le pH de ladite solution aqueuse est dans l'intervalle de 11,0 à 13,5, de préférence dans l'intervalle d'environ 11,5 à 13,5.

16. Procédé selon la revendication 11, dans lequel, après la préparation de ladite solution aqueuse, ledit substrat et ladite solution sont introduits dans une chambre d'un outil de dépôt électrolytique.

17. Procédé selon la revendication 16, dans lequel, après l'immersion dudit substrat dans ladite solution aqueuse, un métal contenant du Cu est déposé sur ladite couche contenant du Cu formée sur ledit substrat dans une chambre dudit outil de dépôt électrolytique au moyen d'un dépôt électrolytique.

18. Procédé selon la revendication 17, dans lequel l'épaisseur de ladite couche contenant du Cu est comprise entre 100 nm et 2000 nm, de préférence en dessous d'environ 600 nm et en dessous d'environ 250 nm.
